(19) Europäisches Patentamt
European Patent Office
Office européen des brevets

(11) **EP 1 249 878 A2**

(12) **EUROPÄISCHE PATENTANMELDUNG**

(43) Veröffentlichungstag:
**16.10.2002   Patentblatt 2002/42**

(51) Int Cl.7: **H01L 35/32**

(21) Anmeldenummer: 02003870.9

(22) Anmeldetag: **21.02.2002**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **15.03.2001  DE 10112383**

(71) Anmelder: **Forschungszentrum Karlsruhe GmbH 76133 Karlsruhe (DE)**

(72) Erfinder: **Schlenker, Dieter 76344 Eggenstein-Leopoldshafen (DE)**

(54) **Thermoelement und daraus aufgebauter Thermogenerator**

(57)   Ein einzelnes Thermoelement besteht aus einem quaderförmigen Trägerkörper aus formbeständigem dielektrischem Material. Eine Seite des Körpers ist mit einem ausgewählten Metall aus der thermoelektrischen Spannungsreihe und die gegenüberliegende Seite mit einem andern daraus beschichtet. Auf einer dritten Seite des Trägerkörpers stoßen die beiden Metallschichten aneinander oder liegen übereinander.

Ein Thermogenerator in seiner elementaren Form besteht aus k solchen zur Säule gestapelten Thermoelementen. wobei sich zwei unmittelbar benachbarte Thermoelemente mit der metallisch gleichartig beschichteten Seite der beiden Seiten berühren und die dritte metallisch beschichtete Seite der Thermoelemente abwechselnd zur einen Seite der Säule und der gegenüberliegenden frei liegen.

Fig. 1

**Beschreibung**

Die Erfindung betrifft ein Thermoelement und einen daraus aufgebauten thermoelektrischen Generator, kurz einen Thermogenerator.

Thermoelektrische Energiewandler wandeln an sie angelegte Temperaturdifferenzen direkt in elektrische Energie um. Damit sind sie lokal als autarke, von einem elektrischen Verteilernetz unabhängige Energiequellen. Die vielfältigen Anwendungen in weiten Bereichen der Technik unterstreichen dieses.

Bestimmend für den Thermogenerator ist die Leistungsstärke, sie bestimmt grundsätzlich die Baugröße und damit den Herstellungsaufwand. Sind die elektrischen Nenndaten wie Quellenspannung, Quellenstrom, bekannt liegt der Thermogenerator in seiner Struktur fest, die bei heutigen Herstellungsverfahren ein fertiges, bis auf Erweiterungen nicht mehr abwandelbares Endprodukt bedeuten.

Der Erfindung liegt die Aufgabe zugrunde, Thermogeneratoren nach dem Baukastenprinzip herstellen zu können. Er soll gewissermaßen hinsichtlich Vorgabe des Nennstrom und der Nennspannung aus seinem einfachsten Element, dem Thermoelement, zusammengebaut werden können.

Die Aufgabe wird durch ein Thermoelement und dem daraus zusammengesetzten Thermogenerator im Kern gelöst. Das einzelne Thermoelement besteht aus einem quaderförmigen Trägerkörper aus formbeständigem dielektrischem Material, dem Isolierkörper.

Eine Seite des Körpers ist mit einem ersten ausgewählten Metall aus der thermoelektrischen Spannungsreihe und die gegenüberliegende Seite mit einem zweiten andern daraus beschichtet.

Eine dritte Seite des Trägerkörpers ist entweder mit einem elektrisch gut leitenden Metall beschichtet, das die beiden aus der thermoelektrischen Spannungsreihe ausgewählten Metalle an den Berührungskanten elektrisch gut leitend kontaktiert, oder

die beiden Metallschichten aus den einander gegenüberliegenden Seiten auf die dritte Seite stoßend oder einander überlappend herübergezogen sind. Auf jeden Fall ist der Übergang zwischen den beiden thermoelektrischen Metallen elektrisch gut leitend. Die Beschichtung erfolgt durch Sputtern, Aufdampfen oder durch Clusterstrahl-Deposition.

Der Thermogenerator besteht in seiner elementaren Form aus k solchen zur Säule gestapelten Thermoelementen. Die natürliche Zahl k ist eine beliebige ≥ 1. Sie sind stets so gestapelt, dass sich zwei unmittelbar benachbarte Thermoelemente mit der metallisch gleichartig beschichteten Seite berühren und die dritte zwischen den beiden metallisch beschichtete Seite der Thermoelemente abwechselnd zur einen Seite der Säule und der gegenüberliegenden frei liegen, so dass eine mäanderförmige Struktur des Leiters des elementaren Thermogenerators zustande kommt.

Die beiden einander gegenüberliegenden Seiten des elementaren Thermogenerators sind mit den metallisch beschichteten dritten Seiten der beteiligten Thermoelemente über die Säulenlänge und Breite gut wärmeleitend mit einer dielektrisch gut wärmeleitenden Schicht bedeckt (Anspruch 2). Diese beiden mit der dielektrischen Schicht beschichteten Seiten des elementaren Thermogenerators sind von je einer metallischen Schicht gut wärmeleitend bedeckt, um thermisch an die davor liegende Umgebung anzukoppeln (Anspruch 3).

Abhängig vom Temperaturunterschied zwischen den Kontaktflächen der beiden thermoelektrischen Metalle auf der einen Seite und der auf der andern Seite, ergibt sich die Spannung an den Klemmen des elementaren Thermogenerators für geradzahlige k zu:

$$U_{eThG} = k/2\ [U_{Temphoch} - U_{Tempnied}],$$

dann exponieren sich das erste und letzte Thermoelement des elementaren Thermogenerators mit der gleichen metallischen, einfach beschichteten Seite.

Für ungeradzahlige k ergibt sich die Spannung zu:

$$U_{eThG} = (k-1)/2\ [U_{Temphoch} - U_{Tempnied}] +/- U_{Temphoch/Tempnied},$$

dann exponieren sich das erste und letzte Thermoelement des elementaren Thermogenerators mit der verschiedenen metallischen, einfach beschichteten Seite.

Das erlaubt einen baukastenartigen Aufbau des Thermogenerators in vielfältiger Stufung. Zur Einstellung der Quellenspannung des aus elementaren Thermogeneratoren zusammengesetzten Thermogenerators liegen m elementare Thermogeneratoren gleichartig, elektrisch zueinander in Reihe. Die natürliche Zahl m ist beliebig ≥ 1. Zur Einstellung des Quellenstromes sind n solche Ketten davon, n ist ebenfalls eine natürliche Zahl ≥ 1, gleichartig elektrisch parallel zueinander geschaltet. Die Leiter aller m x n elementaren Thermogeneratoren mäandern zwischen zwei zueinander parallelen Ebenen. Diese zwei Ebenen sind nach außen zur Umgebung exponiert. Die Wärmestromankopplung wird deshalb dort eingerichtet.

Eine Seite davon ist die wärmere, über die der thermische Energieeintrag von außen erfolgt, die andere ist die kälter gehaltene. Damit ist der zur thermoelektrischen Wandlung notwendige Temperaturunterschied vorhanden. Wie der Thermogenerator über thermotechnische Mittel vollends eingebaut ist, hängt von der technischen Anlage ab. Diese Mittel sind bekannt und vielfältig.

Die elektrische und thermische Festigkeit und die leichte und zuverlässige Handhabbarkeit begrenzen die Minimierung der Geometrie des Aufbaus zu kleinen Dimensionen hin. Der Trägerkörper des einzelnen Thermoelements besteht deshalb aus einem harten Dielektrikum wie Keramik oder Hart-PVC beispielsweise. Die Beschichtungsart sowie die Auswahl des Thermomaterials werden von den elektrischen und thermischen Anforderungen an den Thermogenerator bestimmt.

Anhand der Zeichnung wird die Variabilität und damit die Leistungsfähigkeit eines solchermaßen aufgebauten Thermogenerators erläutert. Es zeigen:

Figur 1 das Thermoelement in seiner Struktur,
Figur 2 den aus k = 6 Thermoelementen aufgebauten elementaren Thermogenerator.

Ein Keramik- oder HART-PVC-Plattenstreifen der die Höhe h, Dicke d(J) und die Breite b hat, wird zuvor beispielsweise in einem Sputterbeschichtungs- oder Bedampfungsprozeß mit den beiden aus der thermoelektrischen Spannungsreihe ausgewählten Metallen X und Y beschichtet, und zwar auf der einen Seite alleine mit dem Metall X, auf der andern alleine mit dem Metall Y. Auf einer der Schmalseiten entlang der einfach metallisch beschichteten beiden Seidenflächen liegen beide Metalle, von der jeweiligen Breitseite herübergezogen, übereinander. Aus dem beschichteten Plattenstreifen werden die Thermoelemente jeweils der Breite b und der Höhe h abgeschnitten oder abgetrennt.

Die Platte als Halbzeug zur Herstellung der Thermoelemente kann auf vielfältige Art mit den beiden Metallen beschichtet werden. Das ist aber hier nicht Gegenstand und wird deshalb nicht weiter ausgeführt. Das oben geschilderte Beschichten ist deshalb auch nur als eine von vielfältigen Möglichkeiten kurz geschildert.

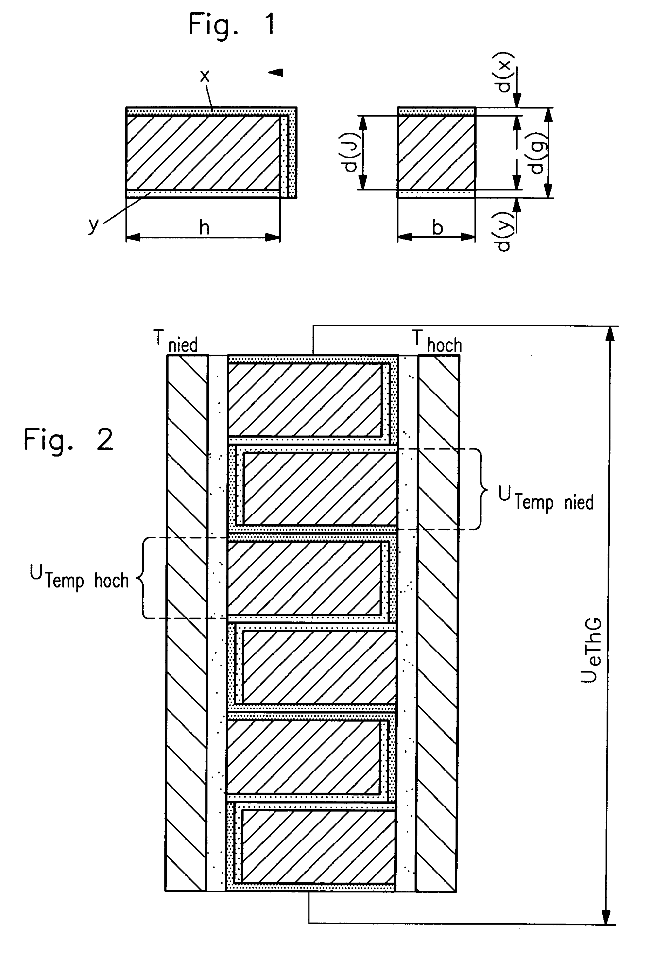

Die Thermoelemente werden in einem Stapelverfahren, das die abwechselnd entgegengesetzte Exponierung der doppelt beschichteten oder stoßenden Metallseite unmittelbar aufeinander folgender Thermoelemente und damit den mäanderförmigen Leiterverlauf durchführt, zum elementaren Thermogenerator mit hier k = 6 Thermoelementen maschinell gestapelt. Die gestapelten Thermoelemente berühren sich breitseitig und gleichmetallisch. Auf der linken Seite in der Figur 2 exponieren sich abwechselnd die metallischen Doppelschichten und die schmalen Keramikoder Hart-PVC-Seiten, auf der gegenüberliegenden Seite entsprechend um ein Thermoelement versetzt. Der so gestapelte und zur guten Kontaktierung verspannte Kern des elementaren Thermogenerators wird dann auf diesen beiden Schmalseiten mit der gut wärmeleitenden dielektrischen Zwischenschicht unmittelbar abgedeckt. Darauf folgt dann auf den beiden Schmalseiten die jeweilige metallische Deckplatte zur thermischen Ankopplung an die unmittelbar davorliegende Umgebung.

Als Beispiel werden die Maße des Thermoelementes in diesem Ausführungsfall aufgelistet:

h = 1 mm,
b = 1 mm,
d(J) = 0,09 mm,
d(x) = d(y) = 0,005 mm,
d(g) = 0,1 mm.

Damit läßt sich eine Packungsdichte von 500 Thermoelementen/cm$^2$ erreichen.

Häufige Metallkombinationen zum Thermoelement sind etwa:

Ni-Cu mit 10 mVcm$^{-2}$K$^{-1}$,
Ni-CrNi mit 20 mVcm$^{-2}$K$^{-1}$,
Bi-Te mit 200 mVcm$^{-2}$K$^{-1}$.

Die aufgeführte, jeweilige thermoelektrische Eigenschaft, [mVcm$^{-2}$K$^{-1}$], wird aus einschlägigen Tabellen entnommen. Andere Metallkombinationen sind, falls zweckmäßig und anwendungsgeeignet, nicht ausgeschlossen.

**Patentansprüche**

**1.** Aus mindestens einem Thermoelement aufgebauter Thermogenerator, **dadurch gekennzeichnet, dass** das einzelne Thermoelement aus einem quaderförmigen Trägerkörper aus formbeständigem dielektrischem Material besteht, eine Seite des Körpers mit einem ausgewählten Metall aus der thermoelektrischen Spannungsreihe und die gegenüberliegende Seite mit einem andern daraus beschichtet ist,
eine dritte Seite des Trägerkörpers:

entweder mit einem elektrisch gut leitenden Metall beschichtet ist, das die beiden aus der thermoelektrischen Spannungsreihe ausgewählten Metalle an den Berührungskanten elektrisch gut leitend kontaktiert,
oder die beiden Metallschichten aus den einander gegenüberliegenden Seiten auf die dritte Seite stoßend oder einander überlappend herübergezogen sind,
der Thermogenerator in seiner elementaren Form aus k solchen, k ist eine natürliche Zahl $\geq$ 1, zur Säule gestapelten Thermoelementen besteht, wobei
sich zwei unmittelbar benachbarte Thermoelemente mit der metallisch gleichartig beschichteten Seite der beiden Seiten berühren und die dritte metallisch beschichtete Seite der Thermoelemente abwechselnd zur einen Seite der Säule und der gegenüberliegenden frei liegen, so dass eine mäanderförmige Struktur des Leiters des elementaren Thermogenerators vorliegt.

2. Thermoelement und daraus aufgebauter Thermogenerator nach Anspruch 1, **dadurch gekennzeichnet, dass** die beiden einander gegenüberliegenden Seiten des elementaren Thermogenerators mit den metallisch beschichteten dritten Seiten der beteiligten Thermoelemente über die Säulenlänge und Breite gut wärmeleitend mit einer dielektrisch gut wärmeleitenden Schicht beschichtet sind.

3. Thermoelement und daraus aufgebauter Thermogenerator nach Anspruch 2, **dadurch gekennzeichnet, dass** diese beiden mit der dielektrischen Schicht beschichteten Seiten des elementaren Thermogenerators von je einer metallischen Schicht gut wärmeleitend bedeckt sind, um thermisch an die davor liegende Umgebung anzukoppeln.

4. Thermoelement und daraus aufgebauter Thermogenerator nach Anspruch 3, **dadurch gekennzeichnet, dass** zur Einstellung der Quellenspannung des aus elementaren Thermogeneratoren zusammengesetzten Thermogenerators m elementare Thermogeneratoren gleichartig, elektrisch zueinander in Reihe liegen, m ist eine natürliche Zahl $\geq$ 1,
zur Einstellung des Quellenstromes n solche Ketten davon, n ist eine natürliche Zahl $\geq$ 1, gleichartig elektrisch parallel zueinander und
alle m x n elementaren Thermogeneratoren des Thermogenerators zwischen zwei zueinander parallelen Ebenen liegen, zwischen denen der Leiter jeden elementaren Thermogenerators mäandert.

# Fig. 1

# Fig. 2